# EUROPÄISCHE PATENTSCHRIFT

(11) **EP 1 979 141 B1**
(45) Veröffentlichungstag und Bekanntmachung des Hinweises auf die Patenterteilung: **01.08.2012**
(21) Anmeldenummer: 07702959.3
(22) Anmeldetag: 23.01.2007
(51) Int. Cl.: B23D 59/00, H05K 3/00

(54) **VERFAHREN ZUR VISUALISIERUNG VON AUF LEITERPLATTEN EINWIRKENDEN TRENNKRÄFTEN**
METHOD FOR REPRESENTING DEPANELING FORCES ACTING UPON CIRCUIT BOARDS
PROCÉDÉ DE REPRÉSENTATION DE FORCES DE SÉPARATION AGISSANT SUR DES CARTES DE CIRCUITS

(30) Priorität: 23.01.2006 DE 102006003348
(43) Veröffentlichungstag der Anmeldung: 15.10.2008
(73) Patentinhaber: Robert Bosch GmbH, 70442 Stuttgart (DE)
(72) Erfinder: DINGELDEIN, Willi, 64720 Michelstadt (DE)
(86) Internationale Anmeldenummer: PCT/EP2007/000549
(87) Internationale Veröffentlichungsnummer: WO 2007/082776

(56) Entgegenhaltungen:
- DD-A1- 135 932
- DE-A1- 1 665 214
- DE-A1- 19 930 639

## Beschreibung

Die Erfindung betrifft ein Verfahren zur Visualisierung von Trennkräften in Verbindung mit Leiterplatten, welche mittels einer Trennvorrichtung bearbeitet werden.

Die Trennung von bereits mit Bauteilen bestückten Leiterplatten kann zur Beschädigung der in unmittelbarer nähe der Trennlinie angebrachten Bauteile führen, da innerhalb der Leiterplatte beim Trennvorgang mechanische Spannungen auftreten, welche zu einer Auswölbung der Leiterplatte im Eingriffbereich der Trennvorrichtung führen.

Die Offenlegungsschrift DE 1665 214 zeigt beispielsweise eine Leiterplatte, welche entlang einer festgelegten Trennlinie (Vorritzung) teilbar ist. Diese Trennlinie wird entweder mittels einer Trennvorrichtung mechanisch nachbearbeitet, z.B. gesägt, oder sie wirkt als Sollbruchstelle. Dabei treten mechanische Verformungen an der Leiterplatte auf.

Die Offenlegungsschrift DE19930639 offenbart ebenfalls ein Verfahren und eine Vorrichtung zum Zertrennen eines plattenförmigen Gegenstands, insbesondere eines keramischen Substrats für eine elektronische Schaltung in unbestücktem oder bestücktem Zustand.

Es ist bekannt derartige mechanische Verformungen mittels Dehnungsmessstreifen zu erfassen. Dies bedeutet jedoch einen relativ hohen technischen Aufwand und Zeitaufwand sowie hohe Kosten.

Die Patenschrift DD 135 932 A1 offenbart ein Verfahren zur Messung der Krümmung eines Bauteils, bei dem auf eine Oberfläche des Bauteils ein zweites ebenes Messsubstrat relativ zur Oberfläche derart angeordnet wird, dass sich zwischen der Oberfläche und dem Messsubstrat ein Flüssigkeit in einer elastischen Folie befindet.

Der Erfindung liegt die Aufgabe zugrunde ein Verfahren zu entwickeln, mittels dessen Bauteilfehlern, verursacht durch die mechanische Bearbeitung von bestücken Leitenplatten, vorgebeugt werden kann.

Diese Aufgabe wird gelöst durch ein Verfahren gemäß des unabhängigen Anspruchs,

Mittels einer Vorrichtung zur Anbringung der Flüssigkeit wird in einem ersten Verfahrensschritt diese Flüssigkeit auf dem ebenen und horizontal ausgerichteten Trägersubstrat, d.h. einer Leiterplatte, aufgebracht. Das vorzugsweise transparente und ebene Messsubstrat wird anschließend auf die mit Flüssigkeit benetzte Leiterplatte aufgelegt. Das Messsubstrat ist im Gegensatz zum eher nachgiebigen Trägersubstrat mechanisch kaum verformbar. In jedem Falle ist die Steifigkeit des Messsubstratmaterials um ein Vielfaches höher als die des Trägersubstratmaterials. Die hohe Steifigkeit hat zur Folge, dass zur Erzielung einer mechanischen Verformung ein erheblich höherer Kraftaufwand erforderlich ist, als bei der mechanischen Verformung der weicheren Trägerkonstruktion. Die Menge der Flüssigkeit muss so bemessen sein, dass das Messsubstrat aufgrund der Adhäsionskraft an der Leiterplattenoberfläche haftet. Verformt sich nun die Trägerkonstruktion relativ zum Messsubstrat, wird die zwischen beiden Substraten vorhandene Flüssigkeit verdrängt. Die Intensität dieser Verdrängung ist direkt proportional zur Intensität der Verformung des Trägersubstrates. Wird diese Intensität nun visuell oder messtechnisch erfasst, so sind Rückschlüsse auf die mechanische Verformung möglich. Anhand dieser Rückschlüsse kann die mechanische Belastung des Trägersubstrates gezielt beeinflusst werden. Damit kann aktiv der mechanischen Belastung (Spannungen) bezüglich der am Trägersubstrat fest angeordneten Bauteile vorgebeugt werden, womit die Aufgabe gelöst ist.

Bevorzugt wird das Verfahren zur Festlegung von Mindestabständen der im Randbereich des Trägersubstrates angeordneten Bauteile verwendet. Speziell die im Randbereich angeordneten Bauteile erfahren eine höhere mechanische Belastung als die weiter vom Randbereich beabstandeten Bauteile. Damit ist es möglich mittels des erfindungsgemäßen Verfahrens und abhängig von der Trennmethode den geringst möglichen Abstand zwischen Bauteil und Trägersubstratrand zu ermitteln.

Alternativ wird das Verfahren zur Festlegung der erforderlichen Mindestabstände von auf dem Trägersubstrat entlang einer Trennlinie angeordneten Perforationsausnehmungen verwendet. Untersuchungen haben gezeigt, dass abhängig vom Querschnitt und dem Abstand der Perforationsausnehmungen, vorzugsweise Bohrungen, eine mehr oder weniger ausgeprägte mechanische Belastung in Form einer Auswölbung beim Trennen des Trägersubstrates bzw. der Leiterplatte auftritt. Bei einem Perforationsbohrungsdurchmesser von etwa 0,65 mm bis 0,75 mm, speziell 0,7 mm und einem Perforationsbohrungsabstand, gemessen von Bohrlochmitte zu Bohrlochmitte, von etwa 0,8 mm wurde beispielsweise eine sehr geringe Auswölbung mittels des erfindungsgemäßen Verfahrens festgestellt. Trennliniennah montierte Bauelemente auf zu trennenden Leiterplatten erfahren dadurch nur eine sehr geringe mechanische Belastung. Weitere sinnvolle Bohrungsdurchmesser liegen bei 0,5 mm und Bohrungsmittelpunktabstände bei 1,0 mm; 1,3 mm; 1,5 mm; 1,8 mm und 2,0 mm.

Bevorzugt wird das Messsubstrat mittels einer transparenten Platte, beispielsweise einer Glasplatte realisiert. Hierbei ist sichergestellt, dass die Steifigkeit wesentlich höher gegenüber dem Leiterplattenmaterial ist. Aufgrund der Transparenz lässt sich die Verdrängung der Flüssigkeit bei äußerer Krafteinwirkung visuell verfolgen.

Besonders bevorzugt umfasst die Platte eine Skalierung. Die Skalierung dient zum Ablesen der Verformungsintensität und kann durch entsprechende Versuche abhängig von den verwendeten Materialien oder Abständen der Substrate oder der verwendeten -Flüssigkeitsmenge einen wiederholbaren und vergleichbaren Messvorgang ermöglichen.

Ganz besonders bevorzugt umfasst die Flüssigkeit einen Farbstoff, welcher die Verdrängung der. Flüssigkeit für das Auge leicht erfassbar macht, wenn bei einer mechanischen Belastung des Trägersubstrates die Flüssigkeit zwischen Trägersubstrat und Messsubstrat aufgrund der mechanischen Verformung des Trägersubstrates zumindest teilweise verdrängt wird.

Üblicherweise wird die mechanische Belastung durch Beaufschlagung des Trägersubstrates mittels einer speziellen Trägersubstrattrennvorrichtung insbesondere eines Rollmessers, verursacht. Das Rollmesser bewirkt eine schnelle und effektive Trennung der Leiterplatten.

Vorteilhafterweise wird die Vorschubkraft der Trennvorrichtung mittels einer Kraftmessvorrichtung ermittelt. Hierdurch sind weitere Optimierungen in Verbindung mit dem erfindungsgemäßen Verfahren bezüglich der Kraftwirkung auf die Leiterplatte möglich. Es kann dann die optimale Vorschubkraft ermittelt werden, bei der die Verformungen minimal ausfallen.

Speziell handelt es sich bei den Bauelementen um elektrisch aktive und/oder passive und auf an dem Trägersubstrat mittels Verlötung angeordnete Bauteile, insbesondere um SMD - Bauteile und/oder diskrete Bauteile wie Keramikkondensatoren. Diese Bauelemente sind gegenüber mechanischer Spannungen besonders empfindlich, so dass die Vorteile des Verfahrens hier ganz besonders zum Tragen kommen.

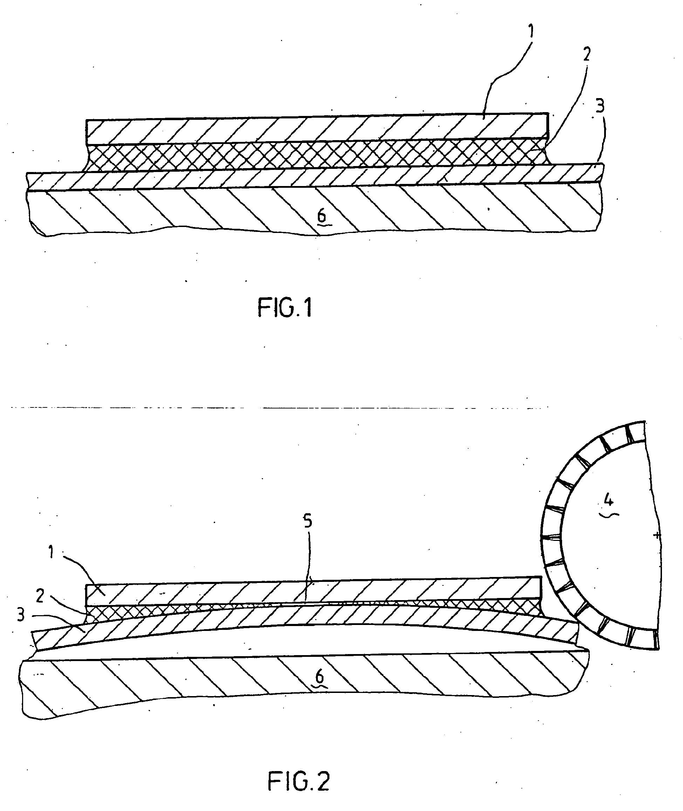

Nachfolgend wird die Wirkung der Erfindung anhand der Figuren 1 und 2 erläutert. Es zeigen:
Figur 1: Schematisch den Querschnitt durch die erfindungsgemäße Anordnung ohne mechanische Belastung.
Figur 2: Schematisch den Querschnitt durch die erfindungsgemäße Anordnung mit mechanischer Belastung

In den Figuren 1 und 2 ist eine Glasplatte 1, eine Flüssigkeitsschicht 2 und eine Leiterplatte 3 sowie eine Führungsschiene 6 für eine Trennscheibe 4 gezeigt, die als Unterlage dient. Figur 2 zeigt zusätzlich die Trennscheibe 4, sowie einen Raum 5, aus dem die Flüssigkeit 2 zwischen Glasplatte 1 und Leiterplatte 3 verdrängt wurde.

Bei dem erfindungsgemäßen Verfahren wird auf eine im wesentlichen ebene erste Leiterplatte 3 für elektrische Bauelemente eine ebene Glasplatte 1 mit im wesentlich glatter Oberfläche relativ zur Leiterplatte 3 derart angeordnet, dass die Glasplatte 1 mittels einer zwischen der Leiterplatte 3 und der Glasplatte 1 eingebrachten Flüssigkeit 2 unter Ausnutzung des Kapillareffektes (Adhäsionskräfte) an der Leiterplattenoberfläche haftet. Die Flüssigkeit, beispielsweise eine ölige Flüssigkeit oder Wasser (Bei den Versuchen wurde Wasser mit schwarzer Tinte eingefärbt), enthält einen Farbstoff, um die in Figur 2 gezeigte Verdrängung 5 durch Verformung der Leiterplatte 3 bei Krafteinwirkung durch die Trennscheibe 4 auf die Leiterplatte 3 deutlich zu machen. An der Trennvorrichtung kann eine Kraftmessvorrichtung (nicht gezeigt) angeordnet sein, welche die Vorschubkraft der Trennscheibe messtechnisch erfasst. An der Leiterplatte 3 sind üblicherweise SMD - Bauteile (nicht gezeigt) und/oder diskrete Bauteile (nicht gezeigt) wie Keramikkondensatoren angelötet.

### Bezugszeichenliste:

- 1: Glasplatte
- 2: Flüssigkeit
- 3: Leiterplatte
- 4: Trennscheibe
- 5: Leerraum
- 6: Unterlage/Führungsschiene

## Patentansprüche

1. Verfahren, bei dem auf eine im wesentlichen ebene Leiterplatte (3) für Bauelemente ein zweites ebenes Messsubstrat (1) relativ zur Leiterplatte (3) derart angeordnet wird, dass das ebene Messsubstrat (1) mittels einer zwischen der Leiterplatte (3) und dem Messsubstrat (1) einbringbaren Flüssigkeit (2) unter Ausnutzung von Adhäsionskräften (Kapillareffekt) an der Leiterplattenoberfläche haftet,
wobei bei einer mechanischen Belastung der Leiterplatte (3) die Flüssigkeit zwischen Leiterplatte (3) und Messsubstrat (1) aufgrund einer mechanischen Verformung der Leiterplatte (3) zumindest teilweise verdrängt (5) wird, wobei die Intensität der Verdrängung visuell oder messtechnisch erfasst wird.

2. Verfahren nach Anspruch 1, wobei dieses zur Festlegung von Mindestabständen der Bauteile relativ zum Randbereich der Leiterplatte (3) dient.

3. Verfahren nach Anspruch 1, wobei dieses zur Festlegung der erforderlichen Mindestabstände von auf der Leiterplatte (3) entlang einer Trennlinie angeordneten Perforationsausnehmungen dient.

4. Verfahren nach einem der vorhergehenden Ansprüche, wobei das Messsubstrat (1) mittels einer transparenten Platte (1), insbesondere einer Glasplatte (1), realisiert ist.

5. Verfahren nach Anspruch 4, wobei die transparente Platte (1) eine Skalierung umfasst.

6. Verfahren nach einem der vorhergehenden Ansprüche, wobei die Flüssigkeit (2) einen Farbstoff umfasst.

7. Verfahren nach einem der vorhergehenden Ansprüche, wobei die mechanische Belastung durch Beaufschlagung der Leiterplatte (3) mittels einer Leiterplattentrennvorrichtung (4), insbesondere eines Rollmessers (4), verursacht ist.

8. Verfahren nach Anspruch 7, wobei die Vorschubkraft der Trennvorrichtung mittels einer Kraftmessvorrichtung ermittelt wird.

9. Verfahren nach einem der vorhergehenden Ansprüche, wobei es sich bei den Bauelementen um elektrisch aktive und/oder passive und auf an dem Leiterplatte (3) mittels Verlötung angeordnete Bauteile handelt, insbesondere um SMD - Bauteile und/oder diskrete Bauteile, wie beispielsweise Keramikkondensatoren.

## Claims

1. Method in which a substantially planar circuit board (3) for components has a second planar measuring substrate (1) arranged on it and in relation to it in such a way that the planar measuring substrate (1) adheres to the surface of the circuit board by means of a liquid (2) that can be introduced between the circuit board (3) and the measuring substrate (1), by using forces of adhesion (capillary effect),
the liquid between the circuit board (3) and the measuring substrate (1) being at least partially displaced (5) when there is mechanical loading of the circuit board (3), on account of a mechanical deformation of the circuit board (3), the intensity of the displacement being detected visually or by measuring instruments.

2. Method according to Claim 1, serving for establishing minimum distances of the components in relation to the edge region of the circuit board (3).

3. Method according to Claim 1, serving for establishing the required minimum distances between perforations arranged on the circuit board (3) along a separating line.

4. Method according to one of the preceding claims, the measuring substrate (1) taking the form of a transparent plate (1), in particular a glass plate (1).

5. Method according to Claim 4, the transparent plate (1) comprising a scaling.

6. Method according to one of the preceding claims, the liquid (2) comprising a dye.

7. Method according to one of the preceding claims, the mechanical loading being caused by the circuit board (3) being acted upon by means of a circuit board separating device (4), in particular a rolling cutter (4).

8. Method according to Claim 7, the advancing force of the separating device being determined by means of a force measuring device.

9. Method according to one of the preceding claims, the components being electrically active and/or passive components that are arranged on the circuit board (3) by means of soldering, in particular SMD components and/or discrete components, such as for example ceramic capacitors.

## Revendications

1. Procédé dans lequel un deuxième substrat plan de mesure (12) est disposé par rapport à la carte de circuit (3), sur une carte de circuit (3) essentiellement plane prévue pour les composants, de telle sorte que le substrat plan de mesure (1) adhère à la surface de la carte de circuit au moyen d'un liquide (2) apte à être apporté entre la carte de circuit (3) et le substrat de mesure (1) en utilisant des forces d'adhérence (effet capillaire),
dans lequel le liquide situé entre la carte de circuit (3) et le substrat de mesure (1) est au moins partiellement refoulé (5) par une déformation mécanique de la carte de circuit (3) lorsqu'une sollicitation mécanique est exercée sur la carte de circuit (3), l'intensité du refoulement pouvant être détectée visuellement ou en utilisant une technique de mesure.

2. Procédé selon la revendication 1, utilisé pour définir des distances minimales entre les composants et la bordure de la carte de circuit (3).

3. Procédé selon la revendication 1, utilisé pour définir des distances minimales nécessaires entre des découpes par perforations disposées sur la carte de circuit (3) le long d'une ligne de séparation.

4. Procédé selon l'une des revendications précédentes, dans lequel le substrat de mesure (1) est réalisé au moyen d'une plaque transparente (1) et en particulier d'une plaque de verre (1).

5. Procédé selon la revendication 4, dans lequel la plaque transparente (1) présente une échelle.

6. Procédé selon l'une des revendications précédentes, dans lequel le liquide (2) contient un colorant.

7. Procédé selon l'une des revendications précédentes, dans lequel la sollicitation mécanique est provoquée lorsqu'un dispositif (4) de découpe de carte de circuit, en particulier un couteau rotatif (4), agit sur la carte de circuit (3).

8. Procédé selon la revendication 7, dans lequel la force d'avancement du dispositif de séparation est déterminée au moyen d'un dispositif de mesure de force.

9. Procédé selon l'une des revendications précédentes, dans lequel les composants sont des composants électriquement actifs et/ou passifs et disposés sur la carte de circuit (3) au moyen d'un brasage, et en particulier des composants SMD et/ou des composants discrets, par exemple des condensateurs en céramique.
